(19) Europäisches Patentamt
European Patent Office
Office européen des brevets

(11) Veröffentlichungsnummer: **0 495 752 B1**

(12) **EUROPÄISCHE PATENTSCHRIFT**

(45) Veröffentlichungstag der Patentschrift: **01.03.95**

(51) Int. Cl.⁶: **C07F 9/53**, C08F 2/50, G03F 7/029

(21) Anmeldenummer: **92810006.4**

(22) Anmeldetag: **07.01.92**

(54) **Bisacylphosphinsulfide.**

(30) Priorität: **14.01.91 CH 84/91**

(43) Veröffentlichungstag der Anmeldung:
**22.07.92 Patentblatt 92/30**

(45) Bekanntmachung des Hinweises auf die Patenterteilung:
**01.03.95 Patentblatt 95/09**

(84) Benannte Vertragsstaaten:
**BE DE FR GB IT NL**

(56) Entgegenhaltungen:
**EP-A- 0 047 902**
**EP-A- 0 184 095**

(73) Patentinhaber: **CIBA-GEIGY AG**
**Klybeckstrasse 141**
**CH-4002 Basel (CH)**

(72) Erfinder: **Rutsch, Werner, Dr.**
**Av. Weck-Reynold 1**
**CH-1700 Fribourg (CH)**
Erfinder: **Hug, Gebhard**
**Rue de Schiffenen 3**
**CH-1700 Fribourg (CH)**
Erfinder: **Köhler, Manfred, Dr.**
**Kehlerstrasse 15**
**W-7800 Freiburg (DE)**

**EP 0 495 752 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft neue Bisacylphosphinsulfide, photohärtbare Zusammensetzungen, die diese Verbindungen enthalten, die Verwendung von Bisacylphosphinsulfiden als Photoinitiatoren zur Photopolymerisation von Verbindungen mit ethylenisch ungesättigten Doppelbindungen und ein Verfahren zur Photopolymerisation solcher Verbindungen mit Bisacylphosphinsulfiden als Photoinitiatoren.

Aus der DE-A-3 034 697 sind Monoacylphosphinsulfide und deren Verwendung als Photoinitiatoren bekannt.

Die EP-A-184 095 beschreibt Bisacylphosphinoxide als Initiatoren für lichtinduzierte Polymerisationsreaktionen.

K. Issleib et al. veröffentlichten in der Z. anorg. allg. Chem. 408, 266-274, (1974) die Synthese von cyclischen Carbonsäurephosphiden, sowie die Umsetzung von 2-Phenyl-2-benzophospholen-1,3-dion mit Schwefel zum entsprechenden Sulfid. Auch der Publikation von Andrew R. Barron et al. im J. Chem. Soc., Chem. Commun. (23), 1753-4, (1987) sind Synthese und spektroskopische Daten des erwähnten Sulfids zu entnehmen.

Es wurde nun gefunden, dass Bisacylphosphinsulfide hervorragende Eigenschaften als Photoinitiatoren zur Polymerisation von Verbindungen mit ethylenisch ungesättigten Doppelbindungen haben.

Gegenstand der Erfindung sind also Verbindungen der Formel I

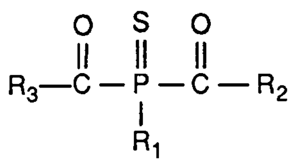
(I),

worin $R_1$ unsubstituiertes $C_1$-$C_{18}$-Alkyl oder durch Phenyl, -CN, $C_1$-$C_{12}$-Alkoxy oder Halogen substituiertes $C_1$-$C_8$-Alkyl, $C_2$-$C_{18}$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch Halogen, $C_1$-$C_{12}$-Alkyl oder $C_1$-$C_{12}$-Alkoxy substituiertes $C_6$-$C_{12}$-Aryl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und $R_2$ und $R_3$ unabhängig voneinander für unsubstituiertes $C_1$-$C_{18}$-Alkyl oder durch Phenyl, Halogen oder $C_1$-$C_{12}$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch $C_1$-$C_{12}$-Alkyl, $C_1$-$C_{12}$-Alkoxy, $C_2$-$C_{12}$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S-oder/und N-haltigen aromatischen heterocyclischen Rest stehen.

$R_1$, $R_2$ und $R_3$ als $C_1$-$C_{18}$-Alkyl können verzweigtes und unverzweigtes Alkyl sein wie z.B. Methyl, Ethyl, Propyl, Isopropyl, n-Butyl, sec-Butyl, iso-butyl, tert-Butyl, Pentyl, Hexyl, tert-Hexyl, Heptyl, Octyl, 2,4,4-Trimethylpentyl, Nonyl, Decyl, Dodecyl, Tetradecyl, Heptadecyl oder Octadecyl. Insbesondere können $R_1$, $R_2$ und $R_3$ für $C_1$-$C_{12}$-Alkyl stehen.

$R_1$, $R_2$ und $R_3$ als ein- oder mehrfach, z.B. ein bis 3-fach, insbesondere ein- oder zweifach, substituiertes $C_1$-$C_8$-Alkyl können z.B. Benzyl, 1-Phenylethyl, 2-Phenylethyl, $\alpha,\alpha$-Dimethylbenzyl, 2-Methoxyethyl, 2-Ethoxyethyl, Diethoxymethyl, 2-Butoxyethyl, 2-Isopropoxyethyl, 2-Butoxypropyl, 2-Octyloxyethyl, Chlormethyl, 2-Chlorethyl oder Trichlormethyl, bevorzugt substituiertes $C_1$-$C_4$-Alkyl, besonders Benzyl, sein. $R_1$ kann auch beispielsweise Cyanomethyl, Cyanoethyl usw. bedeuten.

$R_1$ als $C_2$-$C_{18}$-Alkenyl kann z.B. Allyl, Methallyl, 1,1-Dimethylallyl, Butenyl, 2-Hexenyl, Octenyl, Undecenyl, Dodecenyl oder Octadecenyl, bevorzugt $C_2$-$C_{12}$-Alkenyl, besonders $C_2$-$C_6$-Alkenyl, sein.

$R_2$ und $R_3$ als $C_2$-$C_6$-Alkenyl können z.B. Vinyl, Propenyl, Butenyl oder Hexenyl sein.

$R_1$, $R_2$ und $R_3$ als $C_5$-$C_8$-Cycloalkyl können z.B. Cyclopentyl, Cyclohexyl oder Cyclooctyl, bevorzugt Cyclopentyl und Cyclohexyl, besonders Cyclohexyl, bedeuten. Als substituiertes, z.B. 1- bis 4-fach substituiertes, $C_5$-$C_8$-Cycloalkyl können $R_1$, $R_2$ und $R_3$ z.B. für Methylcyclopentyl, Dimethylcyclopentyl, Methylcyclohexyl, Dimethylcyclohexyl, Diethylcyclohexyl, Methoxycyclopentyl, Dimethoxycyclopentyl, Ethoxycyclopentyl, Diethoxycyclopentyl, Methoxycyclohexyl, Dimethoxycyclohexyl, Ethoxycyclohexyl, Diethoxycyclohexyl, Chlorcyclohexyl, Chlorcyclopentyl, Dichlorcyclohexyl oder Dichlorcyclopentyl stehen. Ist Cycloalkyl substituiert, dann vorzugsweise mit $C_1$-$C_4$-Alkyl.

$R_1$, $R_2$ und $R_3$ als $C_6$-$C_{12}$-Aryl können z.B. Phenyl, $\alpha$-Naphthyl, $\beta$-Naphthyl oder 4-Diphenylyl, bevorzugt Phenyl, darstellen. $R_1$, $R_2$ und $R_3$ als substituiertes $C_6$-$C_{12}$-Aryl enthält vorzugsweise 1 bis 3 Substituenten und ist z.B. Chlorphenyl, Dichlorphenyl, Trichlorphenyl, Difluorphenyl, Tolyl, Mesityl, Ethylphenyl, tert-Butylphenyl, Dodecylphenyl, Methoxyphenyl, Dimethoxyphenyl, Ethoxyphenyl, Hexyloxyphenyl, Methylnaphthyl, Isopropylnaphthyl, Chlornaphthyl oder Ethoxynaphthyl, insbesondere Dimethoxyphenyl, Chlorphenyl und Mesityl, bevorzugt Dimethoxyphenyl. $R_2$ und $R_3$ als substituiertes Aryl können darüber hinaus auch z.B. Methoxyethylphenyl, Ethoxymethylphenyl, Methylthiophenyl, Isopropylthiophenyl oder tert-Butylthiophenyl sein. Alkyl und Alkoxy als Arylsubstituenten haben vorzugsweise 1 - 4 C-Atome und sind insbesondere Methyl oder Methoxy.

$R_1$, $R_2$ und $R_3$ als heterocyclischer Rest können ein- oder mehrkernig, insbesondere ein- oder zweikernig sein, beispielsweise mit annelliertem Benzolring, und bedeuten z.B. Furyl, Thienyl, Pyrrolyl, Pyridyl, Indolyl, Benzoxazolyl, Benzimidazolyl oder Benzthiazolyl sein. Bevorzugt enthält ein solcher heterocyclischer Rest 4-12 C-Atome. Die genannten heterocyclischen Reste können ein- oder mehrfach, z.B. ein- oder zweifach, substituiert sein. Beispiele dafür sind Dimethylpyridyl, Methylchinolyl, Dimethylpyrrolyl, Methoxyfuryl, Dimethoxypyridyl oder Difluorpyridyl.

Halogen bedeutet insbesondere Chlor, Brom oder Fluor, vorzugsweise Chlor.

Ein bevorzugter Gegenstand der Erfindung sind Verbindungen der Formel I, worin $R_1$ unsubstituiertes $C_1$-$C_{12}$-Alkyl oder durch Phenyl, -CN, $C_1$-$C_4$-Alkoxy oder Halogen substituiertes $C_1$-$C_8$-Alkyl, $C_2$-$C_{12}$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch Halogen, $C_1$-$C_{12}$-Alkyl oder $C_1$-$C_4$-Alkoxy substituiertes $C_6$-$C_{12}$-Aryl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und

$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S- oder/und N-haltigen aromatischen heterocyclischen Rest stehen.

Von Interesse sind auch Verbindungen der Formel I, worin $R_1$ unsubstituiertes $C_1$-$C_{12}$-Alkyl oder durch Phenyl, -CN, $C_1$-$C_4$-Alkoxy oder Halogen substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch Halogen, $C_1$-$C_{12}$-Alkyl oder $C_1$-$C_4$-Alkoxy substituiertes $C_6$-$C_{12}$-Aryl bedeutet und

$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl stehen.

Andere bevorzugte Verbindungen der Formel I sind Verbindungen, worin $R_1$ unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl oder unsubstituiertes oder durch Halogen, $C_1$-$C_{12}$-Alkyl oder $C_1$-$C_4$-Alkoxy substituiertes Phenyl bedeutet und

$R_2$ und $R_3$ unabhängig voneinander für unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl oder unsubstituiertes oder durch $C_1$-$C_{12}$-Alkyl, $C_1$-$C_4$-Alkoxy oder Halogen substituiertes Phenyl stehen.

Bevorzugt sind auch solche Verbindungen der Formel I, worin $R_1$ $C_1$-$C_{12}$-Alkyl, Cyclohexyl oder Phenyl-$C_1$-$C_4$-Alkyl bedeutet und $R_2$ und $R_3$ unabhängig voneinander für durch $C_1$-$C_4$-Alkoxy, Halogen oder $C_1$-$C_4$-Alkyl substituiertes Phenyl stehen.

Von Interesse sind auch Verbindungen der Formel I, worin $R_2$ und $R_3$ gleich sind.

Interessante Verbindungen der Formel I sind die, worin $R_1$ $C_1$-$C_8$-Alkyl oder Benzyl bedeutet, $R_2$ und $R_3$ gleich sind und für durch $C_1$-$C_4$-Alkyl oder $C_1$-$C_4$-Alkoxy substituiertes Phenyl stehen.

Die Verbindungen der Formel I werden z.B. durch Umsetzung der entsprechenden Phosphine mit elementarem Schwefel hergestellt:

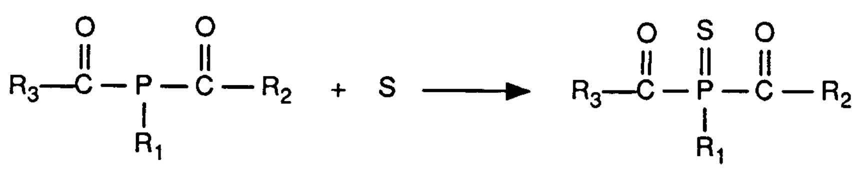

Diese Herstellungsmethode ist z.B. in der DE-A-3 034 697 für Monoacylphosphinsulfide beschrieben. Die Bisacylphosphine werden in Substanz oder gegebenenfalls in einem geeigneten inerten organischen

Lösungsmittel wie z.B. einem Kohlenwasserstoff wie Toluol, Cyclohexan, Chlorbenzol, oder einem aliphatischen oder aromatischen Ether, wie z.B. Dibutylether, Dioxan, Diethylenglycoldimethylether oder Diphenylether, mit einer äquimolaren Menge an elementarem Schwefel umgesetzt. Das entstehende Bisacylphosphinsulfid bzw. dessen Lösung wird durch Filtration von gegebenenfalls noch vorhandenem Schwefel abgetrennt. Die Reaktion wird zweckmässig in einer Inertgasatmosphäre aus z.B. Stickstoff, Argon oder Kohlendioxid, vorzugsweise Stickstoff, durchgeführt. Die Reaktionstemperaturen liegen, je nach Lösungsmittel und verwendeten Edukten zwischen 20 bis 200 °C, insbesondere bei 60 bis 120 °C. Nach dem Entfernen des Lösungsmittels lässt sich das entstandene Bisacylphosphinsulfid durch Destillation oder Umkristallisieren in reiner Form isolieren.

Die Herstellung der Bisacylphosphin-Ausgangsprodukte ist dem Fachmann aus der Literatur bekannt und z.B. in der EP-A-184 095 beschrieben.
So können sie z.B. durch Umsetzung eines entsprechenden Säurehalogenides mit einem Phosphin in Gegenwart einer Base, insbesondere einer Aminbase, erhalten werden. Das Phosphin kann dabei auch beispielsweise Bis(trimethylsilyl)-phenyl-phosphin sein. Bei der Reaktion mit dem Säurehalogenid werden dann die Trimethylsilylgruppen durch den Säure-Rest ersetzt.

Ein weiterer Gegenstand der Erfindung sind Zusammensetzungen enthaltend (a) mindestens eine ethylenisch ungesättigte photopolymerisierbare Verbindung und (b) mindestens eine Verbindung der Formel I.

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Als Komponente (a) kommen solche ethylenisch ungesättigte monomere, oligomere und polymere Verbindungen in Frage, die durch Photopolymerisation zu höhermolekularen Produkten reagieren und hierbei ihre Löslichkeit verändern.

Die ungesättigten Verbindungen können eine oder mehrere olefinische Doppelbindungen enthalten. Sie können niedermolekular (monomer) oder höhermolekular (oligomer) sein.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien. Copolymere, Polyisopren und Isopren-Copolymere, Polymere und Coplymere mit (Meth)-Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-($\beta$-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat,Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glycerindi- und -macrylat, 1,4-Cyclohexandiacrylat, Bisacrylate und Bismethacrylate von Polyethylenglykol mit Molekulargewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen.
Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Polyvinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 50-90 Gew.-% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000-1 000 000. Beispiele sind: Homo- und Copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die erfindungsgemässen photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung
Erfindungsgemäss sind auch Zusammensetzungen, die neben dem Photoinitiator (b) noch mindestens einen weiteren Photoinitiator und/oder andere Additive enthalten.

Enthalten die photopolymerisierbaren Gemische ausser dem Photoinitiator verschiedene andere Additive , so sind dies beispielsweise thermische Inhibitoren, die vor allem während der Herstellung der Zusammensetzungen durch Mischen der Komponenten, eine vorzeitige Polymerisation verhindern sollen, wie z.B. Hydrochinon, Hydrochinonderivate, p-Methoxyphenol, β-Naphthol oder sterisch gehinderte Phenole wie z.B. 2,6-Di(tert-butyl)p-kresol.
Zur Erhöhung der Dunkellagerstabilität können z.B. Kupferverbindungen, wie Kupfernaphthenat, -stearat, oder -octoat, Phosphorverbindungen, wie z.B. Triphenylphosphin, Tributylphosphin, Triethylphosphit, Triphenylphosphit oder Tribenzylphosphit, quarternäre Ammoniumverbindungen, wie z.B. Tetramethylammoniumchlorid oder Trimethyl-benzylammoniumchlorid, oder Hydroxylaminderivate, wie z.B. N-Diethylhydroxylamin, verwendet werden.
Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den Zutritt von Luft verhindert.
Als Lichtschutzmittel können in geringer Menge UV-Absorber, wie z.B. solche vom Benztriazol-, Benzophenon- oder Oxalanilid-Typ, zugesetzt werden. Ebenso lassen sich Lichtschutzmittel vom Typus sterisch gehinderter Amine (HALS) zusetzen.

In bestimmten Fällen kann es von Vorteil sein, Gemische von zwei oder mehr der erfindungsgemässen Photoinitiatoren zu verwenden. Werden neben erfindungsgemässen Photoinitiatoren weitere Photoinitiatoren mitverwendet, kann es sich dabei z.B. um solche vom Typ der Benzophenone, Acetophenonderivate, wie beispielsweise α-Hydroxyalkylphenylketone, Benzoinalkylether und Benzilketale, oder vom Typ der Acylphosphinoxide, Bisacylphosphine, Bisacylphosphinoxide oder Titanocene handeln.

Zur Beschleunigung der Photopolymerisation, vor allem in pigmentierten Zubereitungen, können Amine zugesetzt werden, wie z.B. Triethanolamin, N-Methyl-diethanolamin, p-Dimethylaminobenzoesäure-ethylester oder Michler's Keton. Die Wirkung der Amine kann verstärkt werden durch den Zusatz von aromatischen Ketonen vom Typ des Benzophenons.

Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline.

Weitere übliche Zusätze sind - je nach Verwendungszweck - Füllstoffe, Pigmente, Farbstoffe, Haft-, Netz- oder Verlaufhilfsmittel.

Die photopolymerisierbaren Zusammensetzungen können für verschiedene Zwecke verwendet werden, beispielsweise als Druckfarbe, als Klarlack, als Weisslack, als Anstrichstoff, als Anstrichstoff, z.B. für Aussenanstriche, für photographische Reproduktionsverfahren, für Bildaufzeichnungsverfahren oder zur Herstellung von Druckplatten, für die Herstellung von dreidimensionalen Gegenständen z.B. durch die Stereolithographie oder Massenhärtung, als Zahnfüllmassen, als Klebstoffe, als Ueberzüge von optischen Fasern, für gedruckte elektronische Schaltungen oder zur Beschichtung von elektronischen Teilen.

In Lacken verwendet man häufig Zweikomponeten-Gemische eines Prepolymeren mit einem mehrfach ungesättigten Monomeren oder Dreikomponenten-Gemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehänteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die erfindungsgemässen photohärtbaren Zusammensetzungen eignen sich z.B. als Beschichtungsmittel für Substrate aller Art, z.B. Holz, Papier, Keramik, Kunststoffe wie Polyester und Celluloseacetatfilme und Metalle wie Kupfer und Aluminium, bei denen durch Photopolymerisation eine Schutzschicht oder eine Abbildung aufgebracht werden soll.
Die Beschichtung der Substrate kann erfolgen, indem man eine flüssige Zusammensetzung, eine Lösung

oder Suspension auf das Substrat aufbringt. Das geschieht z.B. durch Tauchen, Aufpinseln, Spritzen oder Reverseroll-Beschichtung. Die Aufträgsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm. Bei Mitverwenden von Lösungsmitteln werden diese nach dem Beschichten entfernt.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Gemische auch zur Herstellung von Druckplatten. Hierbei werden z.B. Gemische von löslichen linearen Polyamiden oder Styrol/Butadien Kautschuk mit photopolymerisierbaren Monomeren, beispielsweise Acrylamiden, und einem Photoinitiator verwendet. Filme und Platten aus diesen Systemen (nass oder trocken) werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung von photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Gegenstand der Erfindung ist auch ein Verfahren zur Photopolymerisation von monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I zugibt und mit Licht im Bereich von 200 bis 600 nm bestrahlt.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 250 und 450 nm liegen. Laserlichtquellen haben den Vorteil, dass keine Photomasken notwendig sind, da der gesteuerte Laserstrahl direkt auf die photohärtbare Schicht schreibt. Im Falle einer Kombination mit Photosensibilisatoren können auch längerwelliges Licht oder Laserstrahlen bis 600 nm verwendet werden.

Die Zusammensetzungen werden zweckmässig durch Mischen der einzelnen Komponenten hergestellt.

Ein weiterer Gegenstand der Erfindung ist eine gehärtete Zusammensetzung, die nach dem oben beschriebenen Verfahren erhalten wird.

Die erfindungsgemässen Bisacylphosphinsulfid-Photoinitiatoren weisen eine gute Löslichkeit in üblicherweise verwendeten, insbesondere apolaren Harzen wie z.B. Siliconen auf.
Ein weiterer Vorteil ist die geringe Vergilbung der mit den erfindungsgemässen Photoinitiatoren gehärteten Zusammensetzungen.

Die nachfolgenden Beispiele erläutern die Erfindung weiter. Angaben in Teilen oder Prozenten beziehen sich, ebenso wie in der übrigen Beschreibung und den Patentansprüchen, auf das Gewicht, sofern nichts anderes angegeben ist.

Beispiel 1: Bis(2,6-dimethoxybenzoyl)-(2-methylpropyl)-phosphinsulfid

a) Bis(2,6-dlmethoxybenzoyl)-(2-methylpropyl)-phosphin

Zu 18,8 g (0,0935 mol) 2,6-Dimethoxybenzoylchlorid in 100 ml Toluol wird bei 100-110 °C innerhalb von 30 Minuten ein Gemisch aus 5 ml (0,0425 mol) (2-Methylpropyl)-phosphin und 13 ml (0,0935 mol) Triethylamin getropft. Zur Vervollständigung der Umsetzung wird bei gleicher Temperatur das Reaktionsgemisch noch 6 Stunden lang gerührt. Das Produkt, sowie Triethylammoniumchlorid fallen dabei als gelblicher Niederschlag aus. Nach dem Abkühlen der Reaktionsmischung wird das Ammoniumsalz durch Zugabe von Wasser gelöst und das Produkt durch Filtration isoliert. Nach der Trocknung im Vakuum erhält man 11,1 g (62,5 % d. Th.) der Titelverbindung als weisses Pulver mit einem Schmelzpunkt von 138-140 °C.

| | | | | | | |
|---|---|---|---|---|---|---|
| Elementaranalyse: | C | ber.:<br>gef.: | 63,15 %<br>63,19 % | H | ber.:<br>gef.: | 6,50 %<br>6,52 % |

b) Bis(2,6-dimethoxybenzoyl)-(2-methylpropyl)-phosphinsulfid

10,0 g (0,024 mol) Bis(2,6-dimethoxybenzoyl)-(2-methylpropyl)-phosphin werden in Toluol vorgelegt und unter Einleiten von Stickstoff auf 60 °C erwärmt, wobei sich das Edukt vollständig löst. Bei 60 °C werden 0.8 g (0,024 mol) Schwefel zugegeben. Die Reaktionsmischung wird dann während 6 Stunden nachgerührt. Nach dem Abkühlen wird am Vakuum eingeengt und der Rückstand aus Essigester umkristallisiert. Man erhält 6,9 g (63,9 % d. Theorie) der Titelverbindung als gelbes Pulver, mit einem Schmelzpunkt von 145-147 °C.

| | | | | | | |
|---|---|---|---|---|---|---|
| Elementaranalyse: | ber.: | C<br>H<br>S | 58,66 %<br>6,04 %<br>7,12 % | gef.: | C<br>H<br>S | 58,59 %<br>6,01 %<br>7,03 % |

Beispiele 2-3:

Die Verbindungen der Beispiele 2 und 3 werden unter Verwendung der entsprechend substituierten Phosphine als Ausgangsverbindungen analog zu der in Beispiel 1 angegebenen Vorschrift hergestellt. Ihre Strukturen und physikalischen Daten sind in Tabelle 1 wiedergegeben.

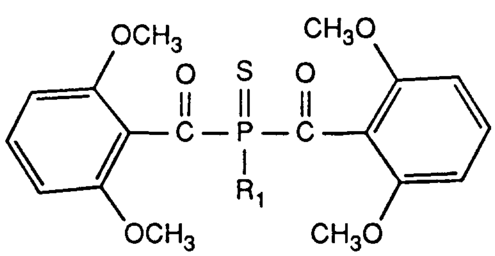

Tabelle 1

| Beispiel Nr. | $R_1$ | Schmelzpunkt [°C] | Elementaranalyse [%] ber. C H S gef. |
|---|---|---|---|
| 2 | 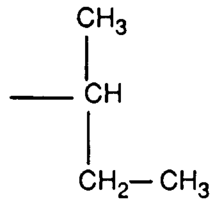 | 117-118 | 58,66 6,04 7,12<br>58,48 6,04 7,30 |
| 3 | 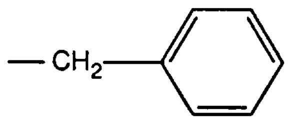 | 138-139 | 61,98 5,20 6,62<br>61,88 5,25 6,83 |

Beispiel 4: Initiator-Reaktivität in einem Weisslack

Es wird eine photopolymerisierbare Zusammensetzung bereitet aus:
(Mengenangaben in Gewichtsteilen)
13,5 ®Ebecryl 830 (Polyesteracrylat der Fa. UCB, Belgien)
0,5 Trimethylolpropan-trisacrylat (Degussa)
1,0 1,6-Hexandiol-diacrylat (Röhm)
5,0 Titandioxid (Rutil-Typ, ®R-TC2 der Fa. Tioxide, Frankreich)
Zu dieser Zusammensetzung wird der zu prüfende Photoinitiator in der aus Tabelle 2 ersichtlichen Menge gemischt. Die Formulierung wird in einer Schichtdicke von 100 µm auf Aluminiumbleche aufgetragen. Die Proben werden dann mit Quecksilbermitteldrucklampen (2 X 80 W/cm; Lampentyp: PPG) bestrahlt. Dabei wird die Probe so oft auf einem Band, welches mit einer Geschwindigkeit von 10 m/min läuft, unter den Lampen hergeführt, bis eine wischfeste Lackoberfläche erreicht ist. Je geringer die Anzahl der Durchläufe (n), desto besser ist die Photoinitatorwirkung der getesteten Verbindung. Die Härte der Probe wird durch Messung der Pendelhärte nach König (DIN 53157) bestimmt. Je höher die Zahl der Sekunden, desto härter ist die getestete Probe. Die Vergilbung der Probe wird als Yellowness-Index (YI) nach ASTM D 1925-70 gemessen. Je kleiner der Wert, desto geringer ist die Vergilbung der Probe. Die Pendelhärte und die Vergilbung werden sofort nach der Härtung und nach einer zusätzlichen Belichtung von 15 Minuten und 16 Stunden unter 4 Lampen des Typs TL 40/03 (Leistung: 40 W; Philips) gemessen. Die Glanzmessung erfolgt nach ASTM D 523 in einem Einfallswinkel von 20 und 60 ° direkt nach der Härtung. Angegeben wird der Anteil des reflektierten Lichts in %. Je höher der Wert, desto besser ist der Glanz.

Die Ergebnisse sind in Tabelle 2 zusammengefasst.

Tabelle 2

| Verbindung aus Beispiel Nr. [Gew.-%] | Reaktivität [n x 10m/min] | Pendelhärte [s] | | | YI | | | Glanz 20/60 ° [in %] |
|---|---|---|---|---|---|---|---|---|
| | | sofort | 15 min | 16 h | sofort | 15 min | 16 h | |
| 1 % Bsp. 1b | 6 | 106 | 157 | 181 | 1,7 | 0,3 | -0,3 | 65/86 |
| 2 % Bsp. 1b | 4 | 125 | 160 | 193 | 3,3 | 0,4 | -0,2 | 78/90 |

Beispiel 5: Initiator-Reaktivität in einem Weisslack

Es wird eine photopolymerisierbare Zusammensetzung bereitet aus:
30 % ®Ebecryl 608 (Epoxy-acrylat der Fa. UCB, Belgien)

15 % Trimethylolpropan-trisacrylat
5 % N-Vinyl-pyrrolidon
50 % Titandioxid (Rutil-Typ, ®R-TC2; Fa. Tioxide, Frankreich)
In diese Formulierung werden zwei Gewichtsprozent des Photoinitiators aus Beispiel 1b eingearbeitet. Die Formulierung wird in einer Schichtdicke von 100 µm auf ein Aluminiumblech aufgetragen. Die 100 µm-Schicht wird durch Bestrahlung mit einer Quecksilbermitteldrucklampe (80 W/cm; Lampentyp: Hanovia) gehärtet. Dabei wird die Probe so oft auf einem Band, welches mit einer Geschwindigkeit von 10 m/min läuft, unter den Lampen hergeführt, bis eine wischfeste Lackoberfläche erreicht ist. Je geringer die Anzahl der Durchläufe (n), desto besser ist die Photoinitatorwirkung der getesteten Verbindung. Die Härte der Probe wird durch Messung der Pendelhärte nach König (DIN 53157) bestimmt. Je höher die Zahl der Sekunden, desto härter ist die getestete Probe. Die Vergilbung der Probe wird als Yellowness-Index (YI) nach ASTM D 1925-70 gemessen. Je kleiner der Wert, desto geringer ist die Vergilbung der Probe. Die Pendelhärte und die Vergilbung werden sofort nach der Härtung und nach einer zusätzlichen Belichtung von 15 Minuten und 16 Stunden unter 4 Lampen des Typs TL 40/03 (Leistung: 40 W; Philips) gemessen. Die Glanzmessung erfolgt nach ASTM D 523 in einem Einfallswinkel von 20 und 60 ° nach 15 Minuten und 16 Stunden zusätzlicher Belichtung mit TL 40/03- Lampen. Angegeben wird der Anteil des reflektierten Lichts in %. Je höher der Wert, desto besser ist der Glanz.
Die Ergebnisse sind in Tabelle 3 zusammengestellt.

Tabelle 3

| Reaktivität [n x 10m/min] | Pendelhärte [s] | | | YI | | | Glanz 20/60 ° [in %] | |
|---|---|---|---|---|---|---|---|---|
| | sofort | 15 min | 16h | sofort | 15 min | 16h | 15 min | 16h |
| 2 | 102 | 139 | 167 | 2,7 | 1,5 | 2,4 | 23/66 | 15/59 |

## Patentansprüche

**1.** Verbindungen der Formel I

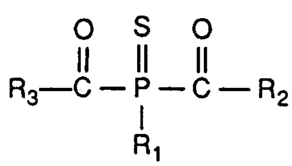 (I),

worin $R_1$ unsubstituiertes $C_1$-$C_{18}$-Alkyl oder durch Phenyl, -CN, $C_1$-$C_{12}$-Alkoxy oder Halogen substituiertes $C_1$-$C_8$-Alkyl, $C_2$-$C_{18}$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch Halogen, $C_1$-$C_{12}$-Alkyl oder $C_1$-$C_{12}$-Alkoxy substituiertes $C_6$-$C_{12}$-Aryl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und
$R_2$ und $R_3$ unabhängig voneinander für unsubstituiertes $C_1$-$C_{18}$-Alkyl oder durch Phenyl, Halogen oder $C_1$-$C_{12}$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch $C_1$-$C_{12}$-Alkyl, $C_1$-$C_{12}$-Alkoxy, $C_2$-$C_{12}$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S- oder/und N-haltigen aromatischen heterocyclischen Rest stehen.

**2.** Verbindungen nach Anspruch 1, worin $R_1$ unsubstituiertes $C_1$-$C_{12}$-Alkyl oder durch Phenyl, -CN, $C_1$-$C_4$-Alkoxy oder Halogen substituiertes $C_1$-$C_8$-Alkyl, $C_2$-$C_{12}$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch Halogen, $C_1$-$C_{12}$-Alkyl oder $C_1$-$C_4$-Alkoxy substituiertes $C_6$-$C_{12}$-Aryl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen

aromatischen heterocyclischen Rest bedeutet und
$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_8$-Alkyl, $C_2$-$C_6$-Aikenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S- oder/und N-haltigen aromatischen heterocyclischen Rest stehen.

**3.** Verbindungen nach Anspruch 2, worin $R_1$ unsubstituiertes $C_1$-$C_{12}$-Alkyl oder durch Phenyl, -CN, $C_1$-$C_4$-Alkoxy oder Halogen substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch Halogen, $C_1$-$C_{12}$-Alkyl oder $C_1$-$C_4$-Alkoxy substituiertes $C_6$-$C_{12}$-Aryl bedeutet und
$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl stehen.

**4.** Verbindungen nach Anspruch 3, worin $R_1$ unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl oder unsubstituiertes oder durch Halogen, $C_1$-$C_{12}$-Alkyl oder $C_1$-$C_4$-Alkoxy substituiertes Phenyl bedeutet und
$R_2$ und $R_3$ unabhängig voneinander für unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl oder unsubstituiertes oder durch $C_1$-$C_{12}$-Alkyl, $C_1$-$C_4$-Alkoxy, oder Halogen substituiertes Phenyl stehen.

**5.** Verbindungen nach Anspruch 4, worin $R_1$ $C_1$-$C_{12}$-Alkyl, Cyclohexyl oder Phenyl-$C_1$-$C_4$-Alkyl bedeutet und $R_2$ und $R_3$ unabhängig voneinander für durch $C_1$-$C_4$-Alkoxy, Halogen oder $C_1$-$C_4$-Alkyl substituiertes Phenyl stehen.

**6.** Verbindungen nach einem der Ansprüche 1 bis 5, worin $R_2$ und $R_3$ gleich sind.

**7.** Verbindungen nach Anspruch 6, worin $R_1$ $C_1$-$C_8$-Alkyl oder Benzyl bedeutet und $R_2$ und $R_3$ für durch $C_1$-$C_4$-Alkyl oder $C_1$-$C_4$-Alkoxy substituiertes Phenyl stehen.

**8.** Zusammensetzung enthaltend (a) mindestens eine ethylenisch ungesättigte photopolymerisierbare Verbindung und (b) mindestens eine Verbindung der Formel I.

**9.** Zusammensetzung nach Anspruch 8, dadurch gekennzeichnet, dass sie neben dem Photoinitiator (b) noch mindestens einen weiteren Photoinitiator und/oder andere Additive enthält.

**10.** Zusammensetzung nach Anspruch 8, enthaltend 0,05 bis 15, insbesondere 0,2 bis 5 Gew.-% der Komponente (b), bezogen auf die Zusammensetzung.

**11.** Verwendung von Verbindungen der in Anspruch 1 definierten Formel I als Photoinitiatoren für die Photopolymerisation ethylenisch ungesättigter Verbindungen.

**12.** Verwendung einer Zusammensetzung nach einem der Ansprüche 8-10 zur Herstellung von Anstrichstoffen, Verbundwerkstoffen, Klebstoffen, Druckplatten, Photoresists für gedruckte elektronische Schaltungen, dreidimensionalen Gegenständen durch Massenhärtung oder Stereolithographie oder als Ueberzug für optische Fasern.

**13.** Verfahren zur Photopolymerisation von Verbindungen mit ethylenisch ungesättigten Doppelbindungen, dadurch gekennzeichnet, dass man eine Zusammensetzung nach Anspruch 8 mit Licht im Bereich von 200 bis 600 nm bestrahlt.

**14.** Verfahren nach Anspruch 13 zur Herstellung von Anstrichstoffen, Verbundwerkstoffen, Druckplatten, Photoresists für gedruckte elektronische Schaltungen, Klebstoffen oder Ueberzügen für optische Fasern.

15. Verfahren nach Anspruch 13, das nach der Methode der Massenhärtung oder Stereolithographie durchgeführt wird.

16. Gehärtete Zusammensetzung, erhalten nach dem Verfahren gemäss Anspruch 13.

## Claims

1. A compound of the formula I

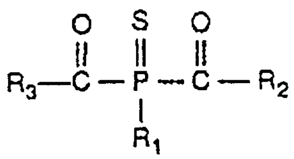 (I),

wherein $R_1$ is unsubstituted $C_1$-$C_{18}$alkyl or $C_1$-$C_8$alkyl which is substituted by phenyl, -CN, $C_1$-$C_{12}$alkoxy or halogen, $C_2$-$C_{18}$alkenyl, unsubstituted $C_5$-$C_8$cycloalkyl or $C_5$-$C_8$cycloalkyl which is substituted by $C_1$-$C_{12}$alkyl, $C_1$-$C_{12}$alkoxy or halogen, unsubstituted $C_6$-$C_{12}$aryl or $C_6$-$C_{12}$aryl which is substituted by halogen, $C_1$-$C_{12}$alkyl or $C_1$-$C_{12}$alkoxy, or a 5- or 6-membered aromatic heterocyclic radical which contains oxygen, sulfur and/or nitrogen and is unsubstituted or substituted by halogen, $C_1$-$C_4$alkyl or $C_1$-$C_4$alkoxy, and
$R_2$ and $R_3$ are each independently of the other unsubstituted $C_1$-$C_{18}$alkyl or $C_1$-$C_8$alkyl which is substituted by phenyl, halogen or $C_1$-$C_{12}$alkoxy, $C_2$-$C_6$alkenyl, unsubstituted $C_5$-$C_8$cycloalkyl or $C_5$-$C_8$cycloalkyl which is substituted by $C_1$-$C_{12}$alkyl, $C_1$-$C_{12}$alkoxy or halogen, unsubstituted $C_6$-$C_{12}$aryl or $C_6$-$C_{12}$aryl which is substituted by $C_1$-$C_{12}$alkyl, $C_1$-$C_{12}$alkoxy, $C_1$-$C_{12}$alkoxyalkyl, $C_1$-$C_4$alkylthio or halogen, or a 5- or 6-membered aromatic heterocyclic radical which contains oxygen, sulfur and/or nitrogen and is unsubstituted or substituted by halogen, $C_1$-$C_4$alkyl or $C_1$-$C_4$alkoxy.

2. A compound according to claim 1, wherein $R_1$ is unsubstituted $C_1$-$C_{12}$alkyl or $C_1$-$C_8$alkyl which is substituted by phenyl, -CN, $C_1$-$C_4$alkoxy or halogen, $C_2$-$C_{12}$alkenyl, unsubstituted $C_5$-$C_8$cycloalkyl or $C_5$-$C_8$cycloalkyl which is substituted by $C_1$-$C_{12}$alkyl, $C_1$-$C_4$alkoxy or halogen, unsubstituted $C_6$-$C_{12}$aryl or $C_6$-$C_{12}$aryl which is substituted by halogen, $C_1$-$C_{12}$alkyl or $C_1$-$C_4$alkoxy, or a 5- or 6-membered aromatic heterocyclic radical which contains oxygen, sulfur and/or nitrogen and is unsubstituted or substituted by halogen, $C_1$-$C_4$alkyl or $C_1$-$C_4$alkoxy, and $R_2$ and $R_3$ are each independently of the other unsubstituted $C_1$-$C_{12}$alkyl or $C_1$-$C_8$alkyl which is substituted by phenyl, halogen or $C_1$-$C_4$alkoxy, $C_2$-$C_6$alkenyl, unsubstituted $C_5$-$C_8$cycloalkyl or $C_5$-$C_8$cycloalkyl which is substituted by $C_1$-$C_{12}$alkyl, $C_1$-$C_4$alkoxy or halogen, unsubstituted $C_6$-$C_{12}$aryl or $C_6$-$C_{12}$aryl which is substituted by $C_1$-$C_{12}$alkyl, $C_1$-$C_4$alkoxy, $C_2$-$C_8$alkoxyalkyl, $C_1$-$C_4$alkylthio or halogen, or a 5- or 6-membered aromatic heterocyclic radical which contains oxygen, sulfur and/or nitrogen and is unsubstituted or substituted by halogen, $C_1$-$C_4$alkyl or $C_1$-$C_4$alkoxy.

3. A compound according to claim 2, wherein $R_1$ is unsubstituted $C_1$-$C_{12}$alkyl or $C_1$-$C_4$alkyl which is substituted by phenyl, -CN, $C_1$-$C_4$alkoxy or halogen, $C_2$-$C_6$alkenyl, unsubstituted $C_5$-$C_8$cycloalkyl or $C_5$-$C_8$cycloalkyl which is substituted by $C_1$-$C_{12}$alkyl, $C_1$-$C_4$alkoxy or halogen, or unsubstituted $C_6$-$C_{12}$aryl or $C_6$-$C_{12}$aryl which is substituted by halogen, $C_1$-$C_{12}$alkyl or $C_1$-$C_{12}$alkoxy, and
$R_2$ and $R_3$ are each independently of the other unsubstituted $C_1$-$C_{12}$alkyl or $C_1$-$C_4$alkyl which is substituted by phenyl, halogen or $C_1$-$C_4$alkoxy, $C_2$-$C_6$alkenyl, unsubstituted $C_5$-$C_8$cycloalkyl or $C_5$-$C_8$cycloalkyl which is substituted by $C_1$-$C_{12}$alkyl, $C_1$-$C_4$alkoxy or halogen, or unsubstituted $C_6$-$C_{12}$aryl or $C_6$-$C_{12}$aryl which is substituted by $C_1$-$C_{12}$alkyl, $C_1$-$C_4$alkoxy, $C_2$-$C_8$alkoxyalkyl, $C_1$-$C_4$alkylthio or halogen.

4. A compound according to claim 3, wherein $R_1$ is unsubstituted $C_1$-$C_{12}$alkyl, phenyl-$C_1$-$C_4$alkyl, unsubstituted or $C_1$-$C_{12}$alkyl-substituted cyclopentyl or cyclohexyl, or unsubstituted phenyl or phenyl which is substituted by halogen, $C_1$-$C_{12}$alkyl or $C_1$-$C_4$alkoxy, and
$R_2$ and $R_3$ are each independently of the other unsubstituted $C_1$-$C_{12}$alkyl, phenyl-$C_1$-$C_4$alkyl, unsubstituted or $C_1$-$C_{12}$alkyl-substituted cyclopentyl or cyclohexyl, or unsubstituted phenyl or phenyl which is substituted by $C_1$-$C_{12}$alkyl, $C_1$-$C_4$alkoxy or halogen.

5. A compound according to claim 4, wherein $R_1$ is $C_1$-$C_{12}$alkyl, cyclohexyl or phenyl-$C_1$-$C_4$alkyl, and $R_2$ and $R_3$ are each independently of the other phenyl which is substituted by $C_1$-$C_4$alkoxy, halogen or $C_1$-$C_4$alkyl.

6. A compound according to any one of claims 1 to 5, wherein $R_2$ and $R_3$ are identical.

7. A compound according to claim 6, wherein $R_1$ is $C_1$-$C_8$alkyl or benzyl and $R_2$ and $R_3$ are $C_1$-$C_4$alkyl- or $C_1$-$C_4$alkoxy-substituted phenyl.

8. A composition comprising (a) at least one ethylenically unsaturated photopolymerisable compound and (b) at least one compound of formula I.

9. A composition according to claim 8 which, in addition to the photoinitiator (b), comprises at least one further photoinitiator and/or other additives.

10. A composition according to claim 8, comprising 0.05 to 15 % by weight, in particular 0.2 to 5 % by weight, of component b), based on the composition.

11. Use of a compound of formula I as defined in claim 1 as photoinitiator for the photopolymerisation of ethylenically unsaturated compounds.

12. Use of a composition according to any one of claims 8 to 10 for the preparation of coating compositions, composites, adhesives, printing plates, photoresists for electronic printed circuits, three-dimensional objects by mass curing or stereolithography, or as coating for optical fibres.

13. A process for photopolymerising compounds containing ethylenically unsaturated double bonds, which comprises irradiating a composition according to claim 8 with light in the range from 200 to 600 nm.

14. A process according to claim 13 for the preparation of coating compositions, composites, printing plates, photoresists for electronic printed circuits, adhesives or coatings for optical fibres.

15. A process according to claim 13, which is carried out according to the method of mass curing or stereolithography.

16. A cured composition obtained by the process according to claim 13.

**Revendications**

1. Composés de formule I

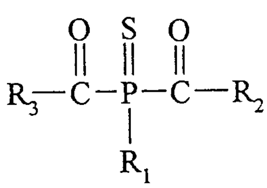

(I)

dans laquelle $R_1$ représente un reste alkyle en $C_1$-$C_{18}$ non substitué ou alkyle en $C_1$-$C_8$ substitué par phényle, -CN, alcoxy en $C_1$-$C_{12}$ ou halogène, un reste alcényle en $C_2$-$C_{18}$, un reste cycloalkyle en $C_5$-$C_8$ non substitué ou substitué par alkyle en $C_1$-$C_{12}$, alcoxy en $C_1$-$C_{12}$ ou halogène, un reste aryle en $C_6$-$C_{12}$ non substitué ou substitué par halogène, alkyle en $C_1$-$C_{12}$ ou alcoxy en $C_1$-$C_{12}$, ou un reste hétérocyclique aromatique de 5 ou 6 chaînons contenant O, S ou/et N, non substitué ou substitué par halogène, alkyle en $C_1$-$C_4$ ou alcoxy en $C_1$-$C_4$, et

$R_2$ et $R_3$ représentent indépendamment l'un de l'autre un reste alkyle en $C_1$-$C_{18}$ non substitué ou alkyle en $C_1$-$C_8$ substitué par phényle, halogène ou alcoxy en $C_1$-$C_{12}$, un reste alcényle en $C_2$-$C_6$, un reste cycloalkyle en $C_5$-$C_8$ non substitué ou substitué par alkyle en $C_1$-$C_{12}$, alcoxy en $C_1$-$C_{12}$ ou halogène, un reste aryle en $C_6$-$C_{12}$ non substitué ou substitué par alkyle en $C_1$-$C_{12}$, alcoxy en $C_1$-$C_{12}$,

alcoxyalkyle en $C_2$-$C_{12}$, alkylthio en $C_1$-$C_4$ ou halogène, ou un reste hétérocyclique aromatique de 5 ou 6 chaînons contenant O, S ou/et N, non substitué ou substitué par halogène, alkyle en $C_1$-$C_4$ ou alcoxy en $C_1$-$C_4$.

**2.** Composés selon la revendication 1, dans lesquels $R_1$ représente un reste alkyle en $C_1$-$C_{12}$ non substitué ou alkyle en $C_1$-$C_8$ substitué par phényle, -CN, alcoxy en $C_1$-$C_4$ ou halogène, un reste alcényle en $C_2$-$C_{12}$, un reste cycloalkyle en $C_5$-$C_8$ non substitué ou substitué par alkyle en $C_1$-$C_{12}$, alcoxy en $C_1$-$C_4$ ou halogène, un reste aryle en $C_6$-$C_{12}$ non substitué ou substitué par halogène, alkyle en $C_1$-$C_{12}$ ou alcoxy en $C_1$-$C_4$ ou un reste hétérocyclique aromatique de 5 ou 6 chaînons contenant O, S ou/et N, non substitué ou substitué par halogène, alkyle en $C_1$-$C_4$ ou alcoxy en $C_1$-$C_4$, et

$R_2$ et $R_3$ représentent indépendamment l'un de l'autre un reste alkyle en $C_1$-$C_{12}$ non substitué ou alkyle en $C_1$-$C_8$ substitué par phényle, halogène ou alcoxy en $C_1$-$C_4$, un reste alcényle en $C_2$-$C_6$, un reste cycloalkyle en $C_5$-$C_8$ non substitué ou substitué par alkyle en $C_1$-$C_{12}$, alcoxy en $C_1$-$C_4$ ou halogène, un reste aryle en $C_6$-$C_{12}$non substitué ou substitué par alkyle en $C_1$-$C_{12}$, alcoxy en $C_1$-$C_4$, alcoxyalkyle en $C_2$-$C_8$, alkylthio en $C_1$-$C_4$ ou halogène, ou un reste hétérocyclique aromatique de 5 ou 6 chaînons contenant O, S ou/et N, non substitué ou substitué par halogène, alkyle en $C_1$-$C_4$ ou alcoxy en $C_1$-$C_4$.

**3.** Composés selon la revendication 2, dans lesquels $R_1$ représente un reste alkyle en $C_1$-$C_{12}$ non substitué ou alkyle en $C_1$-$C_4$ substitué par phényle, -CN, alcoxy en $C_1$-$C_4$ ou halogène, un reste alcényle en $C_2$-$C_6$, un reste cycloalkyle en $C_5$-$C_8$ non substitué ou substitué par alkyle en $C_1$-$C_{12}$, alcoxy en $C_1$-$C_4$ ou halogène, ou un reste aryle en $C_6$-$C_{12}$ non substitué ou substitué par halogène, alkyle en $C_1$-$C_{12}$ ou alcoxy en $C_1$-$C_4$, et

$R_2$ et $R_3$ représentent indépendamment l'un de l'autre un reste alkyle en $C_1$-$C_{12}$ non substitué ou alkyle en $C_1$-$C_4$ substitué par phényle, halogène ou alcoxy en $C_1$-$C_4$, un reste alcényle en $C_2$-$C_6$, un reste cycloalkyle en $C_5$-$C_8$ non substitué ou substitué par alkyle en $C_1$-$C_{12}$, alcoxy en $C_1$-$C_4$ ou halogène, ou un reste aryle en $C_6$-$C_{12}$ non substitué ou substitué par alkyle en $C_1$-$C_{12}$, alcoxy en $C_1$-$C_4$, alcoxyalkyle en $C_2$-$C_8$, alkylthio en $C_1$-$C_4$ ou halogène.

**4.** Composés selon la revendication 3, dans lesquels $R_1$ représente un reste alkyle en $C_1$-$C_{12}$ non substitué, phényl-alkyle en $C_1$-$C_4$, cyclopentyle ou cyclohexyle non substitués ou substitués par alkyle en $C_1$-$C_{12}$, ou phényle non substitué ou substitué par halogène, alkyle en $C_1$-$C_{12}$ ou alcoxy en $C_1$-$C_4$, et

$R_2$ et $R_3$ représentent indépendamment l'un de l'autre un reste alkyle en $C_1$-$C_{12}$ non substitué, phényl-alkyle en $C_1$-$C_4$, cyclopentyle ou cyclohexyle non substitués ou substitués par alkyle en $C_1$-$C_{12}$, ou phényle non substitué ou substitué par alkyle en $C_1$-$C_{12}$, alcoxy en $C_1$-$C_4$ ou halogène.

**5.** Composés selon la revendication 4, dans lesquels $R_1$ est un reste alkyle en $C_1$-$C_{12}$, cyclohexyle ou phényl-alkyle en $C_1$-$C_4$ et $R_2$ et $R_3$ représentent indépendamment l'un de l'autre un phényle substitué par alcoxy en $C_1$-$C_4$, halogène ou alkyle en $C_1$-$C_4$.

**6.** Composés selon l'une des revendications 1 à 5, dans lesquels $R_2$ et $R_3$ sont identiques.

**7.** Composés selon la revendication 6, dans lesquels $R_1$ représente un alkyle en $C_1$-$C_8$ ou un benzyle, et $R_2$ et $R_3$ représentent un reste phényle substitué par alkyle en $C_1$-$C_4$ ou alcoxy en $C_1$-$C_4$.

**8.** Composition contenant (a) au moins un composé photopolymérisable à insaturation éthylénique et (b) au moins un composé de formule I.

**9.** Composition selon la revendication 8, caractérisée en ce qu'elle contient en plus du photoamorceur (b) au moins un autre photoamorceur et/ou d'autres additifs.

**10.** Composition selon la revendication 8, contenant 0,05 à 15, en particulier 0,2 à 5 % en masse du constituant (b), par rapport à la composition.

**11.** Utilisation de composés de formule I définie dans la revendication 1 comme photoamorceurs pour la photopolymérisation de composés à insaturation éthylénique.

**12.** Utilisation d'une composition selon l'une des revendications 8 à 10 pour la préparation de peintures, de matériaux composites, de colles, de plaques à imprimer, de photorésists pour des circuits imprimés électroniques, d'objets en trois dimensions par durcissement en masse ou stéréolithographie ou comme revêtement pour des fibres optiques.

**13.** Procédé de photopolymérisation de composés à doubles liaisons insaturées éthyléniques, caractérisé en ce que l'on expose une composition selon la revendication 8 à de la lumière comprise dans la gamme de 200 à 600 nm.

**14.** Procédé selon la revendication 13 pour la préparation de peintures, de matériaux composites, de plaques à imprimer, de photorésists pour des circuits imprimés électroniques, de colles ou de revêtements pour des fibres optiques.

**15.** Procédé selon la revendication 13, qui est effectué selon une méthode de durcissement en masse ou de stéréolithographie.

**16.** Composition durcie obtenue par le procédé selon la revendication 13.